Europäisches Patentamt

(19) European Patent Office

Office européen des brevets

(11) Veröffentlichungsnummer: **0 055 402**
**A1**

(12) # EUROPÄISCHE PATENTANMELDUNG

(21) Anmeldenummer: 81110207.8

(22) Anmeldetag: 07.12.81

(51) Int. Cl.³: **H 03 G 7/00**

(30) Priorität: 18.12.80 DE 3047766

(43) Veröffentlichungstag der Anmeldung:
07.07.82 Patentblatt 82/27

(84) Benannte Vertragsstaaten:
AT BE CH DE FR GB IT LI LU NL SE

(71) Anmelder: Licentia Patent-Verwaltungs-GmbH
Theodor-Stern-Kai 1
D-6000 Frankfurt/Main 70(DE)

(72) Erfinder: Schröder, Ernst, Dipl.-Ing.
Pinkenburger Strasse 25D
D-3000 Hannover 51(DE)

(74) Vertreter: Einsel, Robert, Dipl.-Ing.
Theodor-Stern-Kai 1
D-6000 Frankfurt/Main 70(DE)

(54) Schaltung mit veränderbarem Übertragungsmass.

(57) Bei einem in seinem Arbeitsbereich begrenzten Kompander wird eine gekrümmte Kennlinie auf folgende Weise erhalten: Ein im Nutzsignalweg (8-13) liegendes Stellglied (12) und ein in einem Zweigweg (14-19) des Kompanders liegendes Stellglied (18) sind mit begrenzenden Widerständen (10, 11, 16, 17) versehen, die unterschiedliche Werte aufweisen. Durch die Bemessung der Widerstände relativ zueinander kann der Kennlinienverlauf in einem weiten Bereich variiert werden.

Fig. 2

EP 0 055 402 A1

Licentia Patent-Verwaltungs-GmbH
Theodor-Stern-Kai 1, 6000 Frankfurt (Main) 70


Hannover,den 19.08.1980
UE2-H Tr/vß      H 80/56


Schaltung mit veränderbarem Übertragungsmaß

Es ist bekannt, die Qualität der Wiedergabe von Tonfrequenzdarbietungen durch Vergrößern des Signal-Rausch-Abstandes durch
ein Kompression-Expansion-System (sogenanntes Kompander-System)
zu verbessern. Die Nutzsignale werden vor dem gestörten Übertragungsweg, z.B. Leitung oder Tonband, in ihrer Amplitude
komprimiert und nach der Übertragung expandiert. Bei Kompandern
für professionale Anwendung wird angestrebt, eine vollkommen
konstante Neigung der Kompander- bzw. Expander-Kennlinien über
einen möglichst großen Regelbereich zu erzielen. Der Vorteil
solcher Kennlinien besteht darin, daß der Eingangspegel des
Expanders von dem Ausgangspegel des Kompressors abweichen kann,
ohne daß sich der Dynamikverlauf des wiedergegebenen Signals
von dem Dynamikverlauf des ursprünglichen Signals unterscheidet.

Dieser für professionelle Anwendungen erwünschte große Regelbereich läßt sich jedoch mit der bei Konsumanwendungen geforderten Kompatibilität mit Übertragungseinrichtungen konstanter
Verstärkung nicht vereinbaren. Die Wiedergabe eines derart
komprimierten Signals ohne Expander hört sich schlecht an, da
z.B. Störungen in Pausen des Eingangssignals stark angehoben
sind. Ebenfalls unzureichend ist der Höreindruck bei einem unkomprimierten Signal, das über einen Expander mit einer
oben erwähnten Regelkennlinie wiedergegeben wird. Hierbei
tritt nämlich eine sehr übertriebene Dynamik der Darbietung
auf.

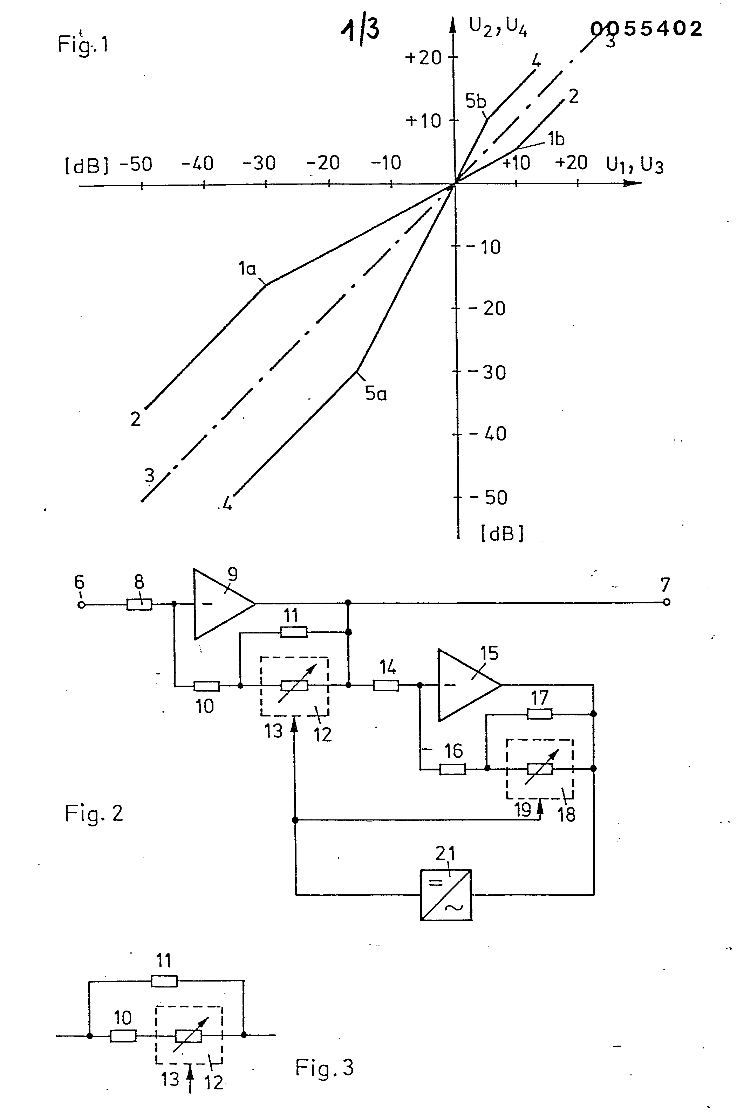

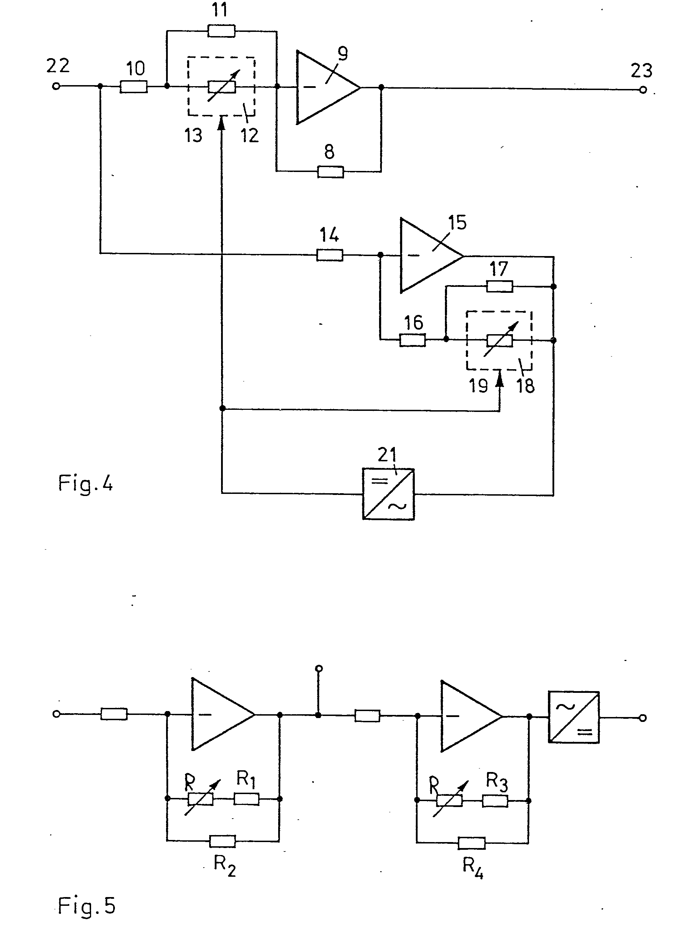

Es ist durch die DE-OS 28 12 431 bekannt, den Arbeitsbereich
des Kompanders zu großen und kleinen Pegeln des Nutzsignales
zu begrenzen, damit eine ausreichende Kompatibilität mit hinsichtlich der Dynamik linear arbeitenden Systemen erhalten
bleibt. Eine nach der Lehre der DE-OS 28 12 431 aufgebauter
Kompressor ist in Fig. 2 der Zeichnung dargestellt. Der Kompressor in Fig. 2 ist nach dem Kettenverstärker-Prinzip aufgebaut: Das Stellglied eines im Nutzsignalweg liegenden Übertragungsgliedes mit veränderbarem Übertragungsmaß und das
Stellglied eines in einem Zweigweg liegenden Übertragungsgliedes sind in ihrem Stellbereich durch parallel und/oder in
Serie geschaltete Widerstände eingeengt. Durch diese Maßnahmen
erhält die Schaltung gemäß Fig. 2 eine in einem Pegeldiagramm
in Fig. 1 wiedergegebene Kennlinie 2. Eine spiegelbildliche
Kennlinie 4 erhält man für einen Expander, wenn man diesen
in äquivalenter Weise gemäß Fig. 4 mit begrenzten Stellgliedern
versieht.

Die Kennlinien 2 und 4 in Fig. 1 sind im Bereich zwischen den
Abknickungen in der gewählten logarithmischen Darstellung linear
(dB-linear), wodurch ihre Reproduzierbarkeit in den Geräten z.
B. einer Fabrikationsserie erleichtert wird. Der beschriebene
abgeknickte Kennlinienverlauf nach Fig. 1 ist zwar bei unterschiedlichen Fertigungsserien gut reproduzierbar, jedoch zeigen
sich auch Nachteile, auf die beispielsweise in der DE-OS 25 29
012 eingegangen ist. Dort ist beschrieben, wie mittels einer
Zusatzschaltung ein gekrümmter Verlauf der Kennlinie im Bereich
des oberen Knicks erreicht werden kann. Bei gewissen Anwendungsfällen ist es  erwünscht, auch den unteren Knick  der Kennlinie
abzurunden. Insbesondere wenn eine gute Kompatibilität mit
lineraren Systemen angestrebt wird, sind abgerundete Übergänge zwischen einzelnen Kennlinienstücken vorzuziehen.

Der Erfindung liegt die Aufgabe zugrunde, eine Schaltungsanordnung zur Dynamik-Kompression und/oder Expansion anzugeben,
bei der der Kennlinienverlauf weitgehend variiert werden kann
und bei der eine gute Reproduzierbarkeit der Kennlinie bei Geräten einer Serie gewährleistet ist. Der Aufbau von Schaltungen
mit spiegelbildlichen Kennlinien für Kompression und Expansion soll auf einfache Weise möglich sein. Diese Aufgabe wird
durch die im Patentanspruch 1 angegebene Erfindung gelöst.

Die Erfindung wird im folgenden anhand von einem Ausführungsbeispiel erläutert. Es zeigen:

Fig. 1 ein Pegeldiagramm eines bekannten Kompanders,

Fig. 2 die Schaltung des Kompressors des bekannten Kompanders,

Fig. 4 die Schaltung des Expanders,

Fig. 3 eine Schaltungsvariante eines Details der Schaltungen
       nach den Figuren 2 und 4

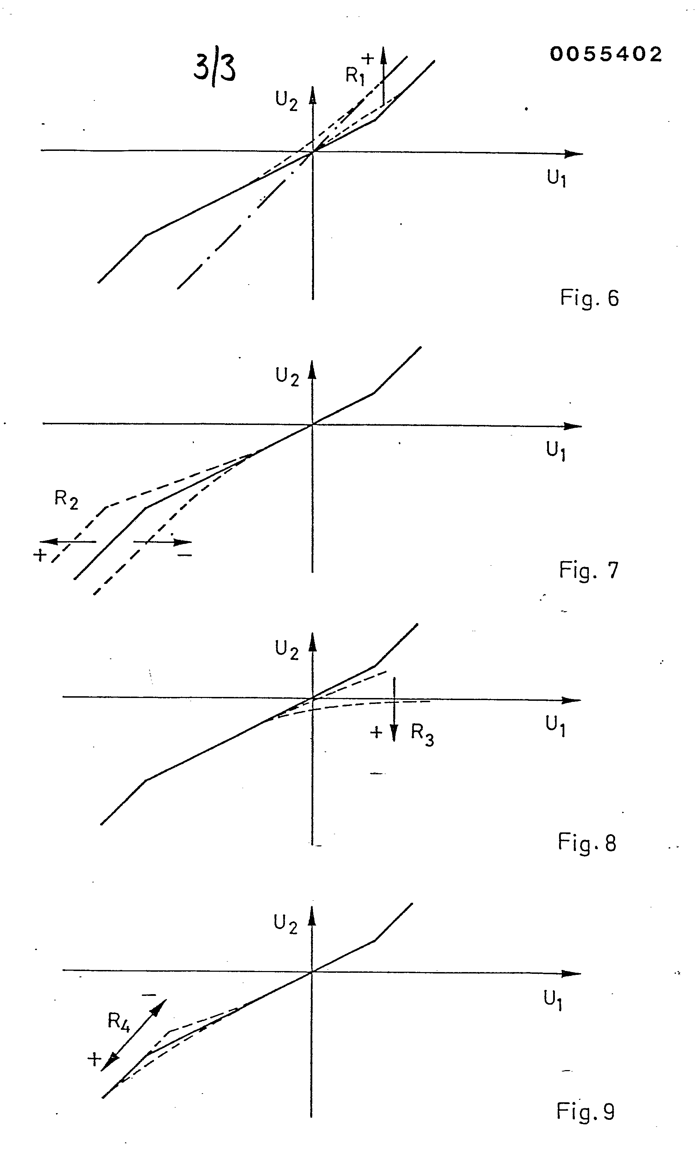

Fig. 5 eine Schaltbildskizze zur Erläuterung der Figuren 6-9
       und

Fig. 6 - 9 die Änderungstendenzen der verschiedenen Kennlinien,
       die bei der erfindungsgemäßen Bemessung der Schaltung
       erhalten werden können.

In Fig. 1 ist ein Pegeldiagramm eines Kompanders in üblicher
Darstellung wiedergegeben. Die zu verarbeitenden Eingangssignale U1 einer Kompressionsschaltung (Fig. 2) liegen auf der
Abzisse und steigen in ihrem Absolutwert von links nach rechts
an. Die Ausgangssignale U2 der Kompressionsschaltung liegen
auf der Ordinate und steigen von unten nach oben an. Bei
einem angenommenen Kompressionsgrad von 2:1 (Kompressor nach
Fig. 2) beträgt die Steigung der Kompressionskennlinie 0,5.

Die Eingangssignale U3 und Ausgangssignale U4 einer der Kompressionsschaltung komplementären Expansionsschaltung (Fig. 4)
sind in das Pegeldiagramm ebenfalls eingezeichnet. Die Steigung 2 der Expanderkennlinie entspricht einem Expansionsgrad von
1:2.

Der Kompander ist auf Arbeitsbereiche zwischen den Punkten 1a -
1b bzw. 5a - 5b begrenzt. Außerhalb dieser Bereiche verlaufen
die Kennlinien parallel zur Linie 3, d.h. die Verstärkung des
Kompressors bzw. Expanders ist in diesen Bereichen konstant.
Durch Überlagerung der Kennlinien 2 und 4 ergibt sich eine
Kennlinie 3, die in der Zeichnung als strichpunktierte Gerade
mit einer Steigung von 1 dargestellt ist.

Bei bekannten Schaltungen bemüht man sich, wie Fig. 1 zeigt,
die Grenzen des Variationsbereiches des Übertragungsmaßes so
zu legen, daß der Kennlinienverlauf innerhalb des benutzten
Arbeitsbereiches dB-linear ist, um eine leichte Reproduzierbarkeit der Kennlinie zu gewährleisten. Als Arbeitsbereich wird
dabei der Pegelbereich oberhalb des verstärkereigenen Rauschens
und unterhalb der Übersteuerungsgrenze angesehen.

Fig. 2 zeigt eine Kompressionsschaltung mit einem Kompressionsgrad von 2. Sie enthält zwei gleichartige in Kette geschaltete
Verstärker 9 und 15 mit elektronisch steuerbaren Widerständen
12 und 18 in der Rückführung zur Veränderung des Übertragungsmaßes. Mit dem Ausgang des Verstärkers 15 ist ein Steuerspannungserzeuger 21 verbunden. Der Ausgang des Steuerspannungserzeugers 21 ist mit Steuereingängen 13 bzw. 19 der steuerbaren
Widerstände 12 bzw. 18 verbunden. Die Steuerung erfolgt in der
Weise, daß die Eingangsspannung des Steuerspannungserzeugers
21 konstant gehalten wird. Das komprimierte Nutzsignal ist an
einer Ausgangsklemme 7 abgreifbar, die mit dem Ausgang des
ersten Kettenverstärkers 9 verbunden ist.

Sowohl der steuerbare Widerstand 12 als auch der steuerbare
Widerstand 18 sind mit einer Parallelimpedanz 11 bzw. 17 und
einer Serienimpedanz 10 bzw. 16 beschaltet. Dadurch ist der
Stellbereich der in der Rückführung der Kettenverstärker geordneten steuerbaren Widerstände eingeengt.

In Fig. 4 ist eine Expanderschaltung dargestellt. Diese Schaltung kann mit den gleichen Elementen aufgebaut werden, wie die Schaltung gemäß Fig. 2. Es sind deshalb für die sich entsprechenden Bauteile auch die gleichen Bezugszeichen verwendet worden. Der steuerbare Widerstand 12 mit den Begrenzungswiderständen 10 und 11 liegt in Fig. 4 nicht im Rückführungsweg des Verstärkers 9, sondern direkt im Nutzsignalweg. Statt dessen liegt der Widerstand 8, der bei der Schaltung gemäß Fig. 2 im Nutzsignalweg lag, jetzt im Gegenkopplungsweg des Verstärkers 9. Die Expanderschaltung gemäß Fig. 4 weist eine zu der Schaltung gemäß Fig. 2 komplementäre Kennlinie auf.

Eine komplementäre Kennlinie erhält man auch, wenn die Schaltung aus Fig. 2 in den Gegenkopplungsweg eines weiteren Operationsverstärkers (nicht dargestellt) geschaltet wird, wobei der Eingang 6 in Fig. 2 mit dem Ausgang des Operationsverstärkers und der Ausgang 7 mit dem invertierenden Eingang des Operationsverstärkers und der Ausgang 7 mit dem invertierenden Eingang des Operationsverstärkers verbunden wird.

Die Begrenzungswiderstände können bei den Schaltungen nach Fig. 2 und 4 auch in der in Fig. 3 gezeigten Weise angeordnet werden.

Während bei bekannten Schaltungen die gesteuerten Stellglieder im Nutzsignalweg und im Zweigweg möglichst gleichartig aufgebaut sind, und mit gleichen Begrenzungswiderständen beschaltet werden, um die Kennlinien gemäß Fig. 1 zu erhalten, sind bei der vorliegenden Schaltung die Begrenzungswiderstände zum Zwecke einer gezielten Beeinflussung der Kennlinie der Gesamtschaltung unterschiedlich gewählt.

Fig. 5 dient zur Erläuterung der Figuren 6 bis 9. Es ist ein Ausschnitt einer Schaltung zur Dynamikkompression und/oder Expansion dargestellt. Die den Stellbereich der Stellglieder einengenden Widerstände sind mit R1 bis R4 bezeichnet.

Die jeweiligen Stellwiderstände mit R.

Für ein sinnvolles Funktionieren der Schaltung nach Fig. 5 ist zunächst zu fordern:

$$R_2 \gg R_1; \quad R_4 \gg R_3$$

Dann wird der minimale Gegenkopplungswiderstand z.B. beim ersten Verstärker durch die Reihenschaltung von R und $R_1$ gebildet. Die Parallelschaltung von $R_2$ fällt dagegen kaum ins Gewicht. Wird R immer kleiner gesteuert, so bestimmt schließlich $R_1$ allein den Gegenkopplungswiderstand, wenn

$$R_{min} \ll R_1 \text{ ist.}$$

Entsprechend wird die Gegenkopplung bei größer werdendem R durch die Parallelschaltung von R und $R_2$ bestimmt, $R_1$ fällt dann nicht mehr ins Gewicht. Wenn schließlich R sehr groß wird

$$R_{max} \gg R_2,$$

so bestimmt $R_2$ allein die Gegenkopplung.

Entsprechendes gilt für $R, R_3, R_4$ beim zweiten Verstärker.

Aus dem Vorstehenden wird deutlich, daß die maximale Verstärkung der Anordnung in Fig. 5 mit $R = R_{max}$ durch $R_2$ und $R_4$ bestimmt wird und die minimale Verstärkung mit $R = R_{min}$ durch $R_1$ und $R_3$ bestimmt wird. Wenn nun $R_1$, $R_3$ oder $R_2, R_4$ unterschiedlich groß sind, so sind an den entsprechenden Kennlinienstellen die Verstärkungen von $V_1$ und $V_2$ (Fig. 5) nicht mehr gleich groß und die Kennlinie weicht von der dB-linearen Kennlinie ab. Wenn der Wert der Stellwiderstände zwischen den jeweiligen Werten $R_1, R_3$ und $R_2, R_4$ liegt, fallen diese Widerstände praktisch nicht ins Gewicht und infolge der Gleichheit der Stellwiderstände ergeben sich dB-lineare Kennlinienteile. Nähern sich die Stellglieder R den Werten von $R_1, R_3$ bzw. $R_2, R_4$, so ergeben sich gekrümmte Übergangsteile. In den Fig. 6 bis 9 ist gezeigt, wie eine Veränderung eines einzelnen

Widerstandes der Widerstände R1 bis R4 sich auf die Kennlinien
im logarithmischen Pegeldiagramm auswirkt. Dabei ist jeweils
davon ausgegangen, daß die übrigen Widerstände unverändert
bleiben. Ein mit einem Pluszeichen versehener Pfeil bedeutet
eine Erhöhung des betreffenden Widerstandes und ein mit einem
Minuszeichen versehener Teil eine Verkleinerung. Wie leicht
ersichtlich ist, kann die Kennlinie der Schaltung durch bestimmte Bemessung der Begrenzungswiderstände relativ zueinander in weiten Bereichen beliebig vorgegeben werden.

In entsprechender Weise veränderte und damit komplementäre
Kennlinien erhält man bei einer Expansionsschaltung, wenn die
gleichen Begrenzungswiderstände wie bei der Kompressionsschaltung verwendet werden. Auf diese Weise können Schaltungen aufgebaut werden mit gekrümmten bzw. abgerundeten Kennlinien, die
die gleichen Präzisionsanforderungen (Reproduzierbarkeit) erfüllen wie bekannte Schaltungen mit dB-linearen Kennlinien.

Die für eine bestimmte gewünschte Kennlinie erforderliche Bemessung der Begrenzungswiderstände wird mit Vorteil mittels
eines numerischen Rechners ermittelt.

Die Erfindung ist auch anwendbar bei einer Schaltung, bei der
gemäß DBP 24 06 258 mehr als zwei Verstärker als Kettenverstärker zusammengeschaltet sind.

Ferner ist bekannt (DE-PS 24 06 258, Anspruch 4), daß um einen
Faktor unterschiedliche Stellglieder verwendet werden können.
Entsprechend müssen dann die Begrenzungswiderstände mit den
gleichen Faktoren versehen werden.

Die üblichen Toleranzen der verwendeten Bauteile haben keinen
wesentlichen Einfluß auf die Linearität der Kennlinien. Erst
bei einem Verhältnis der unterschiedlichen Widerstände von etwa
1,5:1 und größer ergeben sich die beschriebenen Kennlinienverläufe.

0055402

- 1 -                                    H 80/56

P a t e n t a n s p r u c h

Schaltung mit veränderbarem Übertragungsmaß, insbesondere Schaltung zur Dynamik-Kompression und/oder -Expansion, mit einem Übertragungsglied (8 bis 13) in einem Nutzsignalweg und einem Übertragungsglied (14 bis 19) in einem Zweigweg, die je mittels eines Stellgliedes (12;18) in ihrem Übertragungsmaß steuerbar sind, und mit einem Regelspannungserzeuger (21), in dem vom Ausgangssignal des Übertragungsgliedes (14 bis 19) des Zweigweges eine Regelspannung zur Steuerung der Stellglieder (12;18) abgeleitet ist, wobei sowohl dem Stellglied (12) des Übertragungsgliedes im Nutzsignalweg als auch dem Stellglied (18) des Übertragungsgliedes im Zweigweg zur Einengung der Stellbereiche Impedanzen in Reihe (10;16) und/oder parallel (11;17) geschaltet sind, dadurch gekennzeichnet, daß zur Vorgabe bestimmter, insbesondere gekrümmter Pegelkennlinien der Schaltung eine Impedanz (10;11) oder beide Impedanzen (10,11) im Nutzsignalweg zu der entsprechenden Impedanz (16,17) bzw. Impedanzen im Zweigweg unterschiedlich bemessen ist bzw. sind.

0055402

Fig. 1

Fig. 2

Fig. 3

2/3

0055402

Fig.4

Fig.5

0055402

Fig. 6

Fig. 7

Fig. 8

Fig. 9

0055402

Nummer der Anmeldung

EP 81 11 0207

Europäisches
Patentamt

**EUROPÄISCHER RECHERCHENBERICHT**

| Kategorie | EINSCHLÄGIGE DOKUMENTE | | KLASSIFIKATION DER ANMELDUNG (Int Cl ³) |
|---|---|---|---|
| | Kennzeichnung des Dokuments mit Angabe, soweit erforderlich, der maßgeblichen Teile | betrifft Anspruch | |
| A | DE - A - 2 834 545 (LICENTIA)  * Figuren 1,3; Seite 4, Zeilen 4-32; Seite 6, Zeilen 7-21 * | 1 | H 03 G 7/00 |
| A | GB - A - 2 045 587 (LICENTIA)  * Figur; Seite 1, Zeile 31 - Seite 2, Zeile 55 *  & DE - A - 2 912 346 | 1 | |
| A | TECHNISCHE RUNDSCHAU, Band 72, Nr. 14, 14. Oktober 1980, Seiten 9,13 Bern, CH.  D. HOPPNER et al.: "HIGH COM - ein Kompander zur breitbandigen Geräuschunterdrückung"  * Bilder 7,8; Seite 9 * | 1 | RECHERCHIERTE SACHGEBIETE (Int Cl.³)  H 03 G  H 04 B |
| A D | GB - A - 2 017 458 (LICENTIA)  & DE - A - 2 812 431 | 1 | |

KATEGORIE DER GENANNTEN DOKUMENTE

X: von besonderer Bedeutung allein betrachtet
Y: von besonderer Bedeutung in Verbindung mit einer anderen Veröffentlichung derselben Kategorie
A: technologischer Hintergrund
O: nichtschriftliche Offenbarung
P: Zwischenliteratur
T: der Erfindung zugrunde liegende Theorien oder Grundsätze
E: älteres Patentdokument, das jedoch erst am oder nach dem Anmeldedatum veröffentlicht worden ist
D: in der Anmeldung angeführtes Dokument
L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 16-03-1982 | GYSEN |

EPA form 1503.1  06.78